# EUROPEAN PATENT APPLICATION

(11) **EP 1 401 011 A2**
(43) Date of publication of application: **24.03.2004**
(21) Application number: 03251021.6
(22) Date of filing: 20.02.2003
(51) Int. Cl.: H01L 21/00

(54) **Board-conveying robot**

(30) Priority: 18.09.2002 KR 2002056845
(71) Applicant: SAMSUNG ELECTRONICS CO., LTD., Suwon-City, Kyungki-do (KR)
(72) Inventor: Oem, Yo-Se, Kwonsun-Gu, Suwon-City, Kyungki-Do (KR); Lee, Kyung-Cheol, Seoul (KR); Kim, Min-Soo, Jangan-Gu, Suwon-City, Kyungki-Do (KR)
(74) Representative: Robinson, Ian Michael

(57) **Abstract**

A board-conveying robot which improves the construction of a horizontal axis arm (212) and hands (214,218) to reduce a working radius of the board-conveying robot and increase work efficiency thereof. The board-conveying robot includes at least one vertical axis arm (206,210) to control a height of the board-conveying robot and a horizontal axis arm (212) arranged to allow at least one hand (214,218) to move rectilinearly to hold an object (228). The horizontal axis arm (212) is fixedly connected to a head (222). The head is rotatably connected to an upper end of the vertical axis arm (206,210) to move the horizontal axis arm (212) between vertical and horizontal orientations. The board-conveying robot has two hands (214,218) which are constructed to move parallel with each other along two guide rails (216,220) formed in parallel with each other on the horizontal axis arm (212).

## Description

The present invention relates in general to robots and, more particularly, to a board-conveying robot which conveys semiconductor wafers, liquid crystal display boards and other boards.

Robots are used for various purposes in various industrial fields. For example, robots are used to convey boards in a semiconductor manufacturing field. The term "boards" designates semiconductor wafers, liquid crystal display (LCD) panels, unit discs of a disc drive, etc. Such a board is delivered to a corresponding working area of a production line after being loaded onto a conveyance container that is generally called a cassette. A board-conveying robot is used to withdraw the board loaded onto the cassette to execute corresponding processing in a unit manufacturing process of the production line, and then load the processed board again onto the cassette.

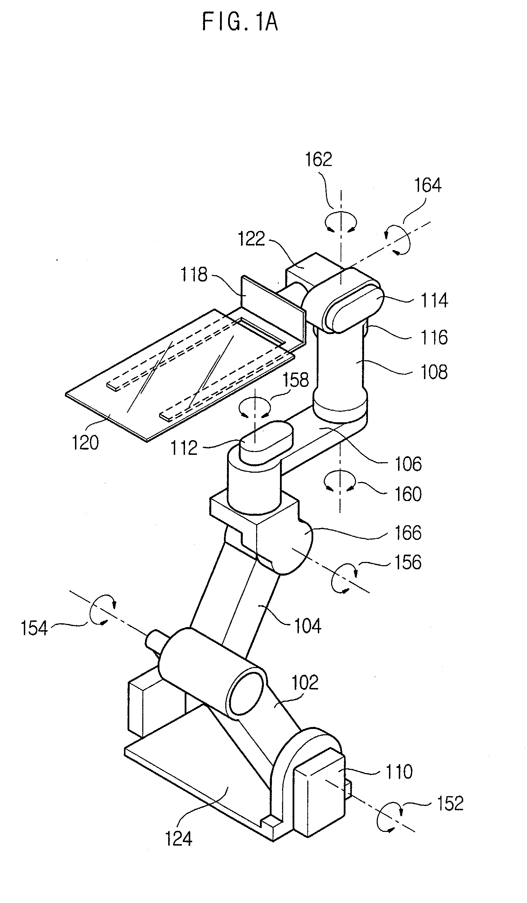

Figure 1A is a perspective view of a conventional board-conveying robot. As shown in Figure 1A, two vertical axis arms 102 and 104 used to control vertical movement are connected to a vertical axis base 124 to be rotatable around respective pivots. The first vertical axis arm 102 is connected to the vertical axis base 124 to be rotatable around a pivot 152. The second vertical axis arm 104 is connected to an upper end of the first vertical axis arm 102 to be rotatable around a pivot 154 and to a vertical axis base 166 to be rotatable around a pivot 156: The first vertical axis arm 102 is rotated by using a motor 110 as an electric power source.

A horizontal axis base 166 to which a first horizontal axis arm 106 is connected to be rotatable around a pivot 158 is connected to an upper end of the second vertical axis arm 104. A second horizontal axis arm 108 is connected to an upper end of the first horizontal axis arm 106. The first horizontal axis arm 106 is rotated by using a motor 112 as an electric power source. An end effector 122 is coupled to an upper end of the second horizontal axis arm 108 to be rotatable around a pivot 162 by using a motor 114 as an electric power source. A hand 118 to hold a board 120 is connected to the end effector 122 to be rotatable around a pivot 164. The hand 118 is rotated around the pivot 164, thus horizontally and vertically holding the board 120.

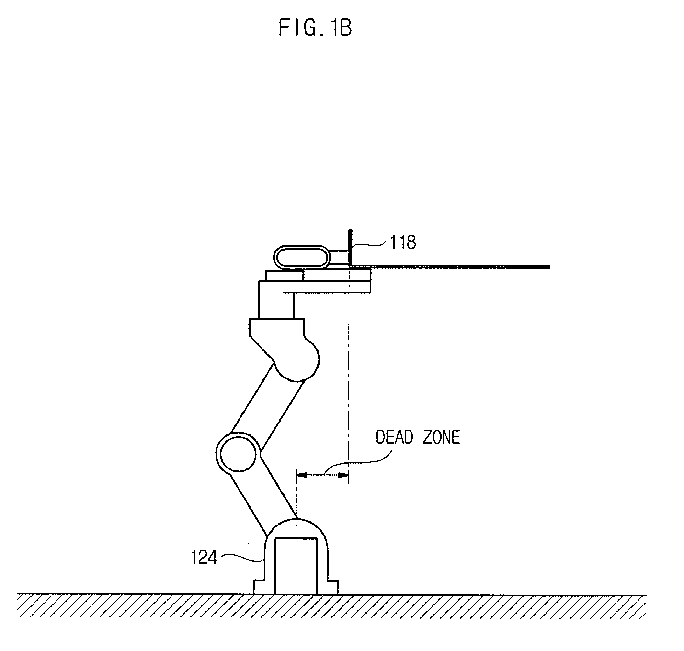

Figure 1B is a view showing the board-conveying robot of Figure 1A whose horizontal axis arms 106 and 108 are maximally folded. As shown in Figure 1B, even though the horizontal axis arms 106 and 108 are maximally folded, there is a dead zone in which the hand 118 is prohibited from further approaching the center of the vertical axis base 124. Due to the dead zone, a working radius of the board-conveying robot is inevitably increased.

The conventional board-conveying robot has only one hand, resulting in limitations in work efficiency. That is, a process of feeding a board into a production line to carry out a corresponding process, conveying a processed board again to the cassette and loading the board onto the cassette is considered as a single cycle. Hence, until an operation of one cycle for one board is completed, the conventional board-conveying robot may not perform another operation (for example, conveyance of a new board). Thus, work efficiency is not greatly increased. That is, until a board fed into a production line has been completely processed, the board-conveying robot must stand by at the production line, inevitably decreasing work efficiency.

To increase work efficiency, a method of operating two hands in the board-conveying robot having the construction of Figure 1A may be considered. However, in the method using two hands, a set of horizontal axis arms must be additionally arranged, and working areas of respective horizontal axis arms must be clearly divided to prevent mutual interference between the two sets of horizontal axis arms. Consequently, work efficiency is not greatly improved and a control system of a board-conveying robot becomes more complicated. Thus, the above method of operating two hands may not be a desirable alternative solution for increasing work efficiency.

An aim of the present invention is to provide a board-conveying robot in which the construction of a horizontal axis arm and hands are improved, ideally to reduce a working radius of the board-conveying robot and increase work efficiency thereof.

Other aims and advantages of the invention will be set forth in part in the description which follows and, in part, will be obvious from the description, or may be learned by practice of the invention.

According to the present invention there is provided an apparatus and method as set forth in the appended claims. Preferred features of the invention will be apparent from the dependent claims, and the description which follows.

In one aspect of the present invention there is provided a board-conveying robot including at least one vertical axis arm designed to control a height of the board-conveying robot and a horizontal axis arm arranged to allow at least one hand to move rectilinearly to hold an object. Further, the horizontal axis arm is fixedly connected to a head which is rotatably connected to an upper end of the vertical axis arm to move the horizontal axis arm between vertical and horizontal orientations. Further, the board-conveying robot has two hands which are constructed to move in parallel with each other along two guide rails formed in parallel with each other on the horizontal axis arm.

For a better understanding of the invention, and to show how embodiments of the same may be carried into effect, reference will now be made, by way of example, to the accompanying diagrammatic drawings in which:
Figure 1A is a perspective view of a conventional board-conveying robot;
Figure 1B is a view showing the board-conveying robot of Figure 1A whose horizontal axis arms are maximally folded;
Figure 2A is a perspective view of a board-conveying robot according to an embodiment of the present invention;
Figure 2B is a view showing the board-conveying robot of Figure 2A with both hands vertically oriented;
Figures 3A and 3B are views showing the internal construction of vertical axis arms of the board-conveying robot of Figure 2A; and
Figure 4 is a view showing another board-conveying robot according to another embodiment of the present invention.

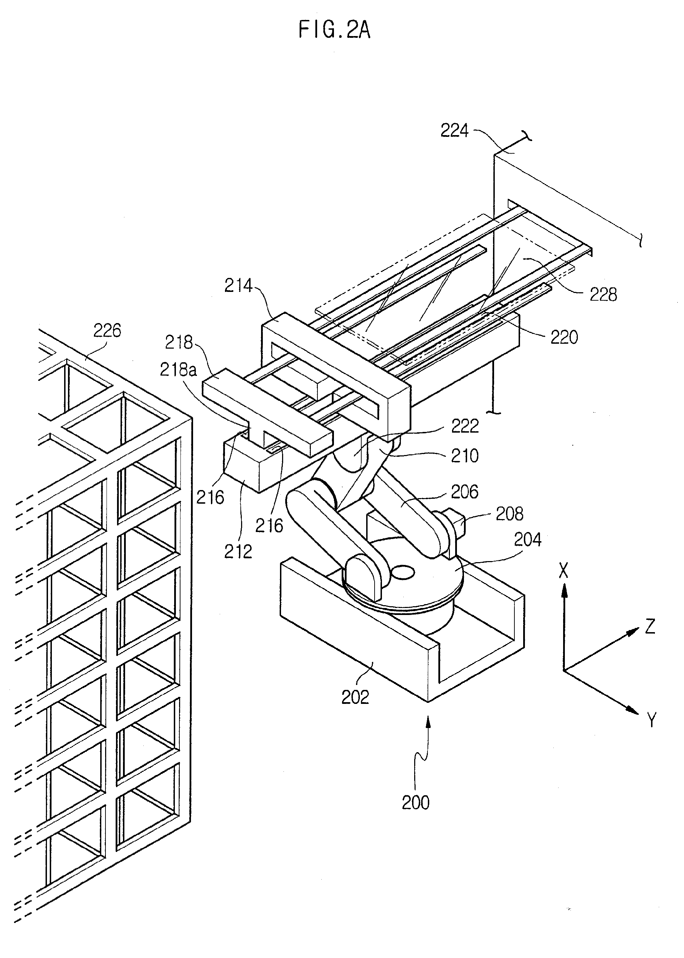

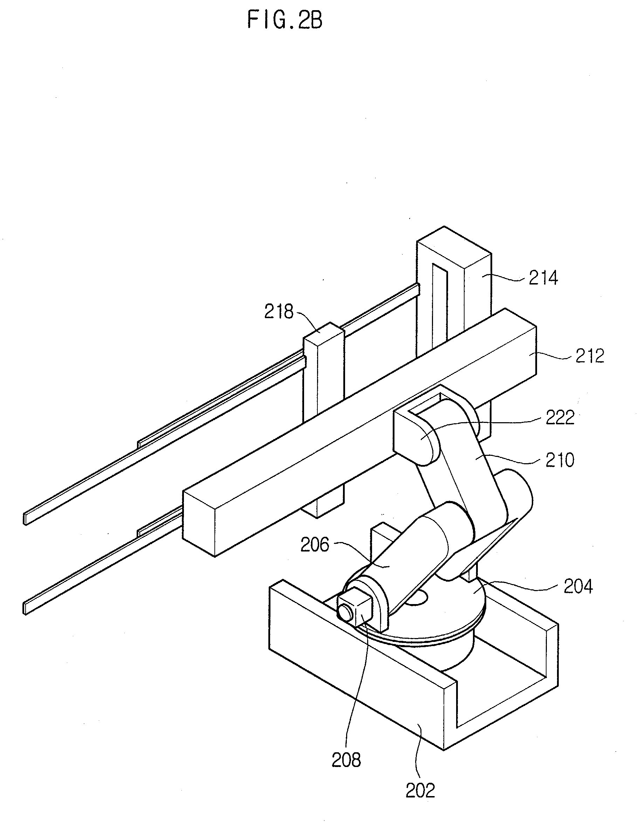

Embodiments of board-conveying robots of the present invention are described in detail with reference to Figures 2A to 4. Figure 2A is a perspective view of a board-conveying robot according to an embodiment of the present invention, and shows that hands 214 and 218 are horizontally oriented. As shown in Figure 2A, a board-conveying robot 200 of the present invention conveys a board 228 between a production line (process chamber or furnace, etc.) 224 and a cassette 226.

A base 204 of the board-conveying robot 200 is arranged to move rectilinearly along a track 202, and is rotatable through 360 degrees on a X-Y plane. The length of the track 202 may be extended if necessary. On the base 204, first and second vertical axis arms 206 and 210 are arranged in order. In this embodiment, the first vertical axis arm 206 is rotated vertically to the X-Y plane by using a motor 208 as an electric power source. The second vertical axis arm 210 subordinated to the movement of the first vertical axis arm 206 is also rotated vertically to the X-Y plane while being rotated opposite to the first vertical axis arm 206.

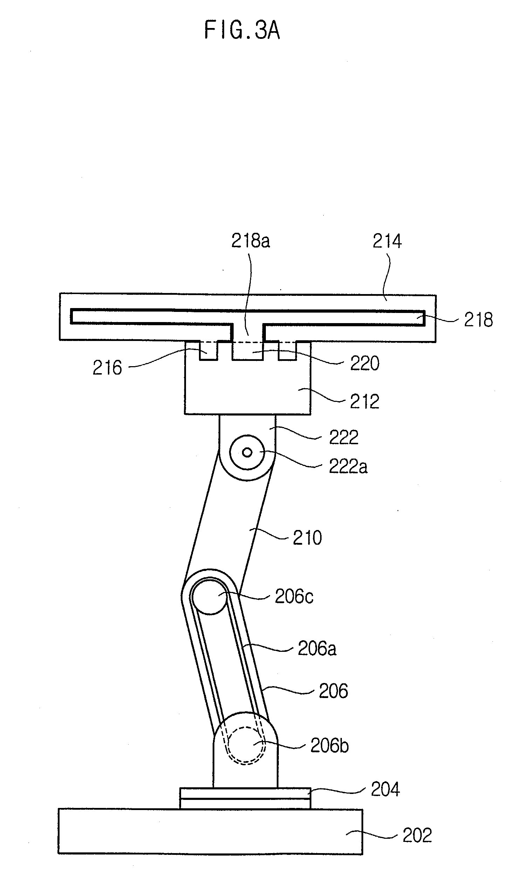

A head 222 is connected to an upper end of the second vertical axis arm 210 to be rotatable vertically by using a motor (222a of Figure 3A) installed in an upper portion of the second vertical axis arm 210 as an electric power source. Contrary to the second vertical axis arm 210 subordinated to the first vertical axis arm 206, the rotation of the head 222 is independent of the first and second vertical axis arms 206 and 210.

A horizontal axis arm 212 is arranged on the head 222, wherein the longitudinal direction of the horizontal axis arm 212 is orthogonal to the rotating direction of the vertical axis arms 206 and 210. Two guide rails 216 and 220 are formed on the horizontal axis arm 212 along the longitudinal direction of the horizontal axis arm 212. Further, two hands 214 and 218 constructed to be complementary are arranged to rectilinearly reciprocate along the guide rails 216 and 220, respectively, in the longitudinal direction of the horizontal axis arm 212. The hands 214 and 218 are used to hold the board 228. The first hand 214 is formed in the shape of a rectangle having an empty center portion to allow the second hand 218 to penetrate through the first hand 214. The center of the lower portion of the rectangle of the first hand 214 is cut to enable a supporter 218a of the second hand 218 to pass through the cut portion. In the horizontal axis arm 212, a mechanical structure is provided to enable the first and second hands 214 and 218 to reciprocate. By this structure, the first and second hands 214 and 218 may freely reciprocate rectilinearly along the longitudinal direction of the horizontal axis arm 212 without mutual interference.

By using the above-described two hands 214 and 218, two boards may be conveyed during a single operating cycle, which is described in detail.
(1) A first board to be fed into a process is withdrawn from the cassette 226 using the first hand 214.
(2) The hands 214 and 218 are set to face the production line 224 by rotating the base 202 at an angle of 180 degrees.
(3) The first board held on the first hand 214 is fed into the production line 224.
(4) A second board to be fed into the production line 224 is withdrawn from the cassette 226 using the first hand 214 while the process of the production line 224 is carried out on the first board.
(5) After the process for the first board is completed, the processed first board is withdrawn from the production line 224 using the second hand 218, and the second board held on the first hand 214 is fed into the production line 224.
(6) The processed first board which is held on the second hand 218 is conveyed to and loaded onto the cassette 226.
(7) The operations (1) to (6) are repeated.

As shown in the above operations (1) to (7), the board-conveying robot of the present invention may withdraw a board from the cassette 226 and allow the board to stand by at the production line 224 while a process for another board is carried out. Therefore, immediately after the process for the board fed into the production line 224 is completed, the processed board may be withdrawn and a new board may be fed into the production line 224. Further, while a process for the board fed into the production line 224 is carried out, the processed board is loaded onto the cassette 226 and thereafter a new board is immediately withdrawn from the cassette 226 to stand by at the production line 224. As described above, high work efficiency is achieved due to the fact that the board-conveying robot is operated using the two hands 214 and 218.

Figure 2B is a view showing the board-conveying robot of Figure 2A with its hands 214 and 218 vertically oriented. As shown in Figure 2B, the head 222 is rotated independently of the first and second vertical axis arms 206 and 210, so the hands 214 and 218 may move to vertical orientations, thus easily performing an operation of vertically drawing out a board or vertically loading a board.

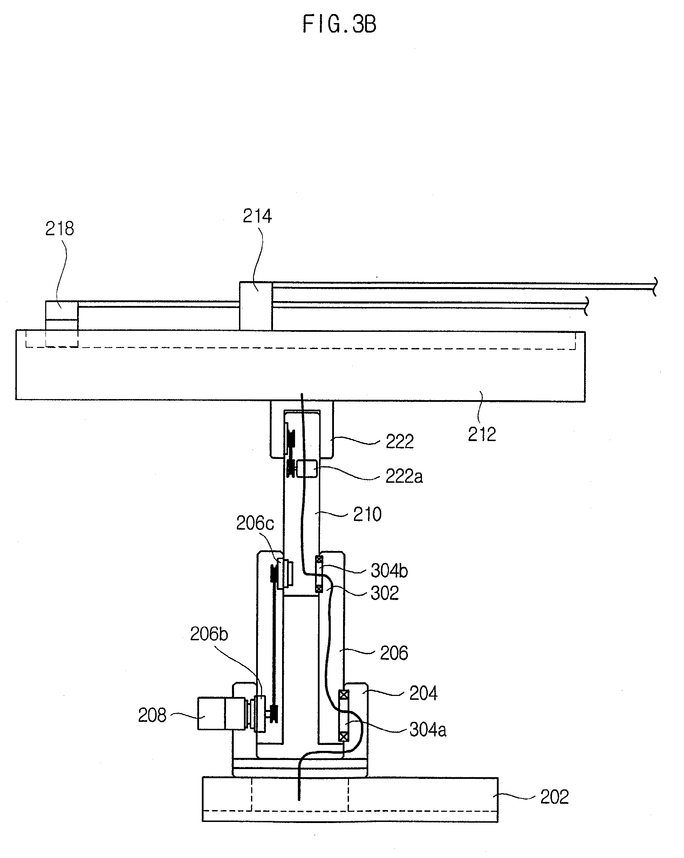

Figures 3A and 3B are views showing the internal construction of the vertical axis arms 206 and 210 of the board-conveying robot of Figure 2A. That is, Figure 3A is a view showing a rotational relationship between the vertical axis arms 206 and 210. As shown in Figure 3A, when the first vertical axis arm 206 is rotated by the motor (208 of Figure 2A), its rotary force is transferred to the second vertical axis arm 210 through a belt 206a, thus rotating the second vertical axis arm 210. At this time, the velocity ratio of two decelerators 206b and 206c is 1:2, and may cause the head 222 to be vertically oriented while maintaining a same position. Therefore, to maintain the horizontal axis arm 212 in a horizontal orientation, the velocity ratio of the two decelerators 206b and 206c and the motor 222a is 1:2:1. However, since the head 222 is independently rotated by the motor 222a, the rotation of the head 222 at velocity ratios deviating from the above velocity ratio may be performed. In this embodiment, the hands 214 and 218 may move to vertical orientations through the rotation of the head 222. Accordingly, the hands 214 and 218 move to vertical orientations to permit boards to be withdrawn vertically or vertically loaded.

Figure 3B is a view showing the wiring structure within the vertical axis arms 206 and 210 of the board-conveying robot of the present invention. As shown in Figure 3B, wiring holes 304a and 304b are provided within the base 204, the vertical axis arms 206 and 210 and the horizontal axis arm 212 to allow a wire 302 to pass therethrough. Accordingly, control cables and power cables may be installed within the arms 206, 210 and 212 through the wiring holes 304a and 304b.

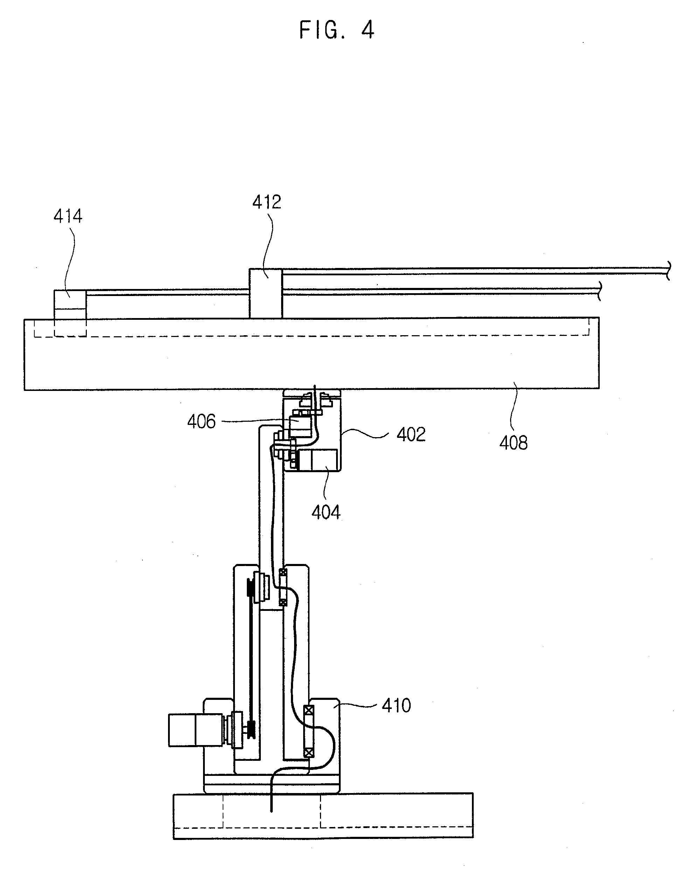

Figure 4 is a view showing another board-conveying robot according to another embodiment of the present invention, and shows that a motor 404 used to rotate a head 402 and a motor 406 used to rotate a horizontal axis arm 408 are mounted within the head 402. The motor 404 rotates the head 402 to move hands 412 and 414 from a horizontal orientation to a vertical orientation. The motor 406 enables the horizontal axis arm 408 to rotate on a horizontal plane. In the embodiment of Figure 4, the motor 406 rotates only the horizontal axis arm 408, wherein the board-conveying robot' may employ a motor having a lower output compared with an embodiment where the board-conveying robot of the present invention is entirely rotated through the rotation of the base 410, thus reducing production costs.

As is apparent from the above description, the present invention provides a board-conveying robot, which can reduce a working radius and increase work efficiency by improving the construction of a horizontal axis arm and hands.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A board-conveying robot comprising:
at least one vertical axis arm (206,210) to control a height of the board-conveying robot;
a horizontal axis arm (212) arranged to allow at least one hand (214,218) to move rectilinearly to hold an object (228) ; and
a head (222) fixedly connected to the horizontal axis arm (212), and rotatably connected to an upper end of the vertical axis arm (206,210) to move the horizontal axis arm (212) between vertical and horizontal orientations.

2. The board-conveying robot according to claim 1, wherein said head (222) is rotated independently of said vertical axis arm (206,210).

3. The board-conveying robot according to claim 1 or 2, wherein said hand (214,218) has a construction to hold a planar object.

4. The board-conveying robot of any preceding claim, wherein:
the horizontal axis arm (212) is arranged to allow first and second hands (214,218) to move rectilinearly in parallel with each other to hold objects.

5. The board-conveying robot according to claim 4, wherein said horizontal axis arm (212) comprises first and second guide rails (216,220) formed thereon parallel with each other, said first and second hands (214,218) moving in parallel with each other along the first and second guide rails (216,220), respectively.

6. The board-conveying robot according to claim 5, wherein said first and second hands (214,218) are constructed to facilitate penetration through the first hand (214) by the second hand (218) when the first and second hands (214,218) move in parallel with each other along the first and second guide rails (216,220), respectively.

7. The board conveying robot according to any preceding claim, comprising a first motor (404) mounted within the head (222) to rotate the head to move the at least one hand (214,218) between horizontal and vertical orientations.

8. The board conveying robot according to any preceding claim, further comprising a second motor (406) mounted within the head (222) to rotate the horizontal axis arm (212) in a horizontal plane.

9. A board-conveying robot comprising:
a first robotic hand (214), arranged to withdraw a first board from a conveyance container (226) and feed the first board to a production line (224); and
a second robotic hand (218), arranged to withdraw a second board from the conveyance container (226) during a production operation on the first board in the production line (224) and feed the second board to the production line (224) upon withdrawal of the first board from the production line (224) by the first robotic hand (214).

10. The board-conveying robot according to claim 9 further comprising:
at least one vertical axis arm (206,210) controlling a height of the board-conveying robot;
a horizontal axis arm (212) arranged to allow the first and second robotic hands (214,218) to move rectilinearly in parallel with each other to hold objects; and
a head (222) fixedly connected to the horizontal axis arm (212), and rotatably connected to an upper end of the vertical axis arm (206,210) to move the horizontal axis arm (212) between vertical and horizontal orientations.

11. The board-conveying robot according to claim 10, wherein said horizontal axis arm (212) comprises first and second guide rails (216,220) formed thereon parallel with each other, said first and second robotic hands (214,218) moving in parallel with each other along the first and second guide rails (216,220), respectively.

12. The board-conveying robot according to claim 11, wherein said first and second robotic hands (214,218) are constructed to facilitate penetration through the first robotic hand (214) by the second robotic hand (218) when the first and second robotic hands (214,218) move in parallel with each other along the first and second guide rails (216,220), respectively.

13. A method for robotic manufacturing comprising:
using a second robotic hand (218) to withdraw a second board from a conveyance container (226) during a production operation on a first board on a production line (224); and
feeding the second board to the production line (224) by the second robotic hand (218) upon withdrawal of the first board from the production line (224) by a first robotic hand (214) to minimize production line delay.

14. The method according to claim 13 further including:
using at least one vertical axis arm (206,210) to control a height of the first and second robotic hands (214,218);
using a horizontal axis arm (212) to allow the first and second robotic hands (214,218) to move rectilinearly in parallel with each other to hold objects; and
connecting a head (222) fixedly to the horizontal axis arm (212) and rotatably to an upper end of the vertical axis arm (206,210) to move the horizontal axis arm (212) between vertical and horizontal orientations.

15. The method according to claim 14, further including using first and second guide rails (216,220) formed on the horizontal axis arm (212) parallel with each other to allow said first and second robotic hands (214,218) to move in parallel with each other along the first and second guide rails (216,220), respectively.

16. The method according to claim 15, further including allowing the second robotic hand (218) to penetrate through the first robotic hand (214) when the first and second robotic hands (214,218) move in parallel with each other along the first and second guide rails (216,220), respectively.

17. A board-conveying robot comprising:
a first robotic hand (214); and
a second robotic hand (218) constructed to facilitate penetration through the first robotic hand (214) when the first and second robotic hands (214,218) move in parallel with each other, respectively.

18. The board-conveying robot according to claim 17, further including at least one vertical axis arm (206,210) to control the height of the board-conveying robot and a horizontal axis arm (212) arranged to allow at least one hand (214,218) to move rectilinearly to hold an object (228) .

19. The board-conveying robot according to claim 18, further including a head (222), rotatably connected to an upper end of the vertical axis arm (206,210) to move the horizontal axis arm (212) between vertical and horizontal orientations.

20. The board-conveying robot according to any of claims 17 to 19, wherein first and second guide rails (216,220), are formed in parallel with each other, to guide the first robotic hand (214) and the second robotic hand (218), respectively.

21. The board-conveying robot according to any of claims 17 to 20, wherein the first and second robotic hands (214,218), respectively, are one of horizontally oriented and vertically oriented.

22. The board-conveying robot according to any of claims 17 to 21, further including an independently rotatable head (222) on a horizontal axis arm (212) that is attached to the first and second robotic hands (214,218), respectively, and arranged to allow at least one hand (214,218) to move rectilinearly to hold an object (228) .

23. The board-conveying robot according to any of claims 19 to 22, further including a first decelerator (206b) coupling one end of a first vertical axis arm (206) to a base (202), a second decelerator (206c) coupling one end of a second vertical axis arm (210) to another end of the first vertical axis arm (206), and a belt (206a) coupling the first and second decelerators (206b,c), respectively, wherein the head (222) is attached to another end of the second vertical axis arm (222) and a velocity ratio of the first and second decelerators (206b,c), respectively, determines an orientation of the horizontal axis arm (212).

24. The board-conveying robot according to any of claims 19 to 23, further including wiring apertures (304a,b) in the base (204), the first and second vertical axis arms (206,210), respectively, and the horizontal axis arm (212), and wiring inserted therethrough for control and power.

25. The board-conveying robot according to any of claims 19 to 24, further including a first motor (404) mounted within the head (222) to rotate the head (222) to move the first and second robotic hands (214,218), respectively from a horizontal orientation to a vertical orientation.

26. The board-conveying robot according to any of claims 19 to 25, further including a second motor (406) mounted within the head (222) to rotate the horizontal axis arm (212) in a horizontal plane.

27. A method of conveying two boards on a first robotic hand (214) and a second robotic hand (218), respectively, during a single manufacturing operating cycle, comprising:
rectilinearly reciprocating the first robotic hand (214) in parallel with the second robotic hand (218) along a first guide rail (216) and a complementary second guide rail (220), respectively, without mutual interference.
